# EUROPÄISCHE PATENTANMELDUNG

(11) **EP 3 751 602 A1**
(43) Veröffentlichungstag der Anmeldung: **16.12.2020**
(21) Anmeldenummer: 19179373.6
(22) Anmeldetag: 11.06.2019
(51) Int. Cl.: H01L 23/367, H01L 23/373

(54) **ISOLIERTES METALLSUBSTRAT FÜR EINE LEISTUNGSELEKTRONISCHE BAUGRUPPE**

(71) Anmelder: Siemens Aktiengesellschaft, 80333 München (DE)
(72) Erfinder: Heimann, Matthias, 14469 Potsdam (DE); Kiefl, Stefan, 80992 München (DE); Lambrecht, Franziska, 80799 München (DE); Müller, Bernd, 16259 Falkenberg (DE); Schellenberg, Christian, 14480 Potsdam (DE); Stegmeier, Stefan, 81541 München (DE); Strogies, Jörg, 14163 Berlin (DE)

(57) **Zusammenfassung**

Die Erfindung betrifft ein isoliertes Metallsubstrat (IMS) für eine leistungselektronische Baugruppe (100). Die Erfindung betrifft weiterhin eine leistungselektronische Baugruppe (100), ein leistungselektronisches Modul (400), ein System (500) sowie ein Element (301,..., 305) . Um leistungselektronische Baugruppen (100) mit isolierten Metallsubstraten (IMS) ohne thermische Interface-Materialien zu ermöglichen wird ein isoliertes Metallsubstrat (IMS) für eine Abwärme erzeugende leistungselektronische Baugruppe (100) vorgeschlagen. Das isolierte Metallsubstrat (IMS) weist eine dielektrische Schicht (10), eine metallische Basis (20) und zumindest eine thermisch-mechanische Schnittstelle (30) auf. Die thermisch-mechanische Schnittstelle (30) ist zum Ableiten der Abwärme aus der Basis (20) und zur thermischen Kontaktierung eines oder mehrerer Elemente (301,..., 305) ausgebildet.

## Beschreibung

Die Erfindung betrifft ein isoliertes Metallsubstrat mit einer thermisch-mechanischen Schnittstelle für eine leistungselektronische Baugruppe. Die Erfindung betrifft weiterhin eine leistungselektronische Baugruppe, ein leistungselektronisches Modul, ein System sowie ein Element.

Konventionelle leistungselektronische Module können mehrere thermische und mechanische Interfaces im primären Kühlpfad aufweisen. Im Rahmen dieser Aufbauten werden typischerweise ein oder mehrere keramische Substrate mit beidseitiger Metallisierung genutzt. Dies kann beispielsweise bei der Erforderlichkeit mehrerer elektrischer Potentiale auf dem Verdrahtungsträger und einer elektrischen Isolation in Richtung des primären Kühlpfads der Fall sein. Dabei dient der keramische Kern des Verdrahtungsträgers als elektrische Isolation, mechanischer Träger und thermisch gut leitfähiger Pfad. Die Anbindung an den Kühlkörper, welcher den Wärmefluss zur Umgebung (Luft oder Flüssigkeit) realisiert, erfolgt entweder über zusätzliche Bodenplatten zur Verbesserung der Wärmespreizung und der mechanischen Stabilität oder auch direkt durch Montage der keramischen Verdrahtungsträger auf den jeweiligen Kühlkörpern. Bei den klassischen Modulen wird aus Gründen der Prozessintegration und teilweise auch der Reparierbarkeit mindestens eines der Interfaces im Kühlpfad mittels eines thermischen Interface-Materials (kurz: TIM, im Englischen: Thermal-Interface-Material) realisiert. Diese Materialien unterliegen als organisches und oft pastöses Material im Feldeinsatz verschiedenen Degradationseffekten. Beispielsweise kommt es unter dem Einfluss von Temperaturwechsellasten zu Verdrängungseffekten des Materials aus den Spalten, was zu örtlichen Defekten im TIM-Layer führt (sog. Auspumpeffekte). Weiterhin unterliegen diese Materialien verschiedenen unerwünschten Alterungserscheinungen.

Der Erfindung liegt die Aufgabe zugrunde leistungselektronische Baugruppen mit isolierten Metallsubstraten ohne thermische Interface-Materialien zu ermöglichen.

Die Aufgabe wird durch ein isoliertes Metallsubstrat für eine Abwärme erzeugende leistungselektronische Baugruppe gelöst. Das isolierte Metallsubstrat weist eine dielektrische Schicht, eine metallische Basis und zumindest eine thermisch-mechanische Schnittstelle auf. Auf der dielektrischen Schicht kann bereits eine Leitebene aus einem elektrisch leitenden Material, z. B. Kupfer, aufgebracht sein. Die Leitebene kann dabei flächig aufgebracht sein, um in einem späteren Prozessschritt strukturiert zu werden oder auch bereits als strukturierte bzw. vorstrukturierte Leitebene ausgebildet sein und dabei bereits erste Leiterbahnen ausbilden.

Die thermisch-mechanische Schnittstelle, im Folgenden auch Schnittstelle genannt, ist dabei zum Ableiten der Abwärme aus der Basis und zur thermischen Kontaktierung eines oder mehrerer Elemente ausgebildet. Die thermische Kontaktierung wird dabei unter anderem durch die mechanische Ausgestaltung der Schnittstelle, wie z.B. Vertiefungen, sichergestellt. Die Elemente können dabei einzelne Kühlkörperrippen, Kühlkörperstäbe oder weitere komplexere (Kühl-)Elemente sein, die zur mechanischen Ausgestaltung der Schnittstelle passen, z.B. gemäß einem Buchse-Stecker und/oder Nut-Feder-Prinzip. Die Elemente dienen dabei dazu, die Wärmeabfuhr aus der Schnittstelle und damit aus der Basis zu verbessern. Die Kombination mehrerer Elemente kann dabei die Kühlfähigkeit der Schnittstelle verbessern. Weiterhin können Lamellen, Pins usw. als Elemente vorgesehen werden. Die Schnittstelle ist dementsprechend so gestaltet, dass die Elemente eine besonders gute thermische Verbindung zur Schnittstelle aufweisen. Dazu können in der Schnittstelle und/oder an den Elementen Oberflächenbeschichtungen vorgesehen sein. Dazu sind insbesondere Oberflächenbeschichtungen geeignet, die intermetallische Phasen bilden, so z.B. verzinnte Elemente bzw. eine verzinnte Schnittstelle.
Der besondere Vorteil der vorliegenden Erfindung liegt darin, die Vorteile eines in das Metallsubstrat integrierten Kühlkörpers nutzen zu können, ohne dessen erhebliche thermische Masse im kompletten Herstellungsprozess mitführen zu müssen. Der Herstellungsprozess kann dabei das Metallsubstrat selbst oder eine leistungselektronische Baugruppe mit dem Metallsubstrat betreffen. Die Handhabung der isolierten Metallsubstrate gemäß der vorliegenden Erfindung unterscheidet sich dabei nicht von der Handhabung von herkömmlichen Metallsubstraten, womit keine oder nur unwesentliche Änderungen an den Handhabungsvorrichtungen im Herstellungsprozess notwendig werden.

In einer weiteren Ausführungsform ist die thermisch-mechanische Schnittstelle zumindest zur teilweisen mechanischen Befestigung der Elemente ausgebildet. Dies kann durch die geometrische Ausgestaltung der thermischen Schnittstelle geschehen. Das Einbringen der Elemente in die Schnittstelle kann dabei als Passung ausgeführt werden und kann durch thermisches Auf-/Einschrumpfen bzw. durch Ausnutzen von thermischen Ausdehnungseffekten in die Schnittstelle eingebracht werden.

In einer weiteren Ausführungsform weist die thermisch-mechanische Schnittstelle eine oder mehrere Aussparungen auf. Die Aussparungen sind dabei derart ausgestaltet, dass sie zur mechanischen Befestigung und/oder zur thermischen Kontaktierung der Elemente dienen. In die Aussparungen können die Elemente zumindest teilweise aufgenommen werden, dies kann beispielsweise durch Einpressen, Einschrauben, sogenannte Snap-In-Elemente realisiert sein. Auch Schraubverbindungen, durch z. B. durch ein Gewinde, das als Aussparung dient, können vorgesehen sein.

In einer weiteren vorteilhaften Ausführungsform sind die Aussparungen so ausgebildet, dass eines oder mehrere der Elemente lateral einführbar sind. Lateral ist dabei als seitlich bezüglich der Ebene, auf der die leistungselektronischen Bauelemente montiert sind, zu verstehen. Dies ist besonders von Vorteil, da so eine übermäßige mechanische Beanspruchung der auf dem isolierten Metallsubstrat montierten empfindlichen leistungselektronischen Bauelemente vermieden wird. Dies ist der Fall, weil die Kräfte bei der Montage der Elemente lediglich in lateraler Richtung auf das isolierte Metallsubstrat und damit nur indirekt und lateral auf die Bauelemente wirken, womit eine erheblich geringere Belastung einhergeht und damit die Ausschussrate (z.B. abgebrochene/gerissene Leistungshalbleiter) gesenkt werden kann. Druckbelastungen auf ggf. vorhandene Bonddrähte und deren Vergussmaterialien können so vollständig vermieden werden, sodass ein unerwünschtes Knicken der Bonddrähte eliminiert werden kann. In anderen Worten ist die Schnittstelle so ausgebildet, dass die Kräfte der Elementmontage nur indirekt auf die Bauelemente wirken und damit bei der Montage der Elemente nur eine geringe Wechselwirkung mit den bereits montierten Bauelementen entsteht.

In einer weiteren vorteilhaften Ausgestaltung ist die thermisch-mechanische Schnittstelle zur formschlüssigen und/oder kraftschlüssigen mechanischen Verbindung mit den Elementen ausgebildet. Die mechanische Verbindung kann dabei bezüglich des Elements lediglich abschnittsweise ausgestaltet sein. Das heißt das Element kann also nur teilweise form- und/oder kraftschlüssig mechanisch mit der Schnittstelle verbunden sein. Die form- und/oder kraftschlüssige mechanische Verbindung ermöglicht der Schnittstelle den mechanischen Halt für die Elemente zu verbessern. Es ist möglich, dass das isolierte Metallsubstrat die Elemente ausschließlich durch die Schnittstelle und deren mechanischen Haltefähigkeiten hält. Ebenso kann die Schnittstelle das isolierte Metallsubstrat selbst tragen, z.B. durch Elemente, die an einem Gestell/Gehäuse vorgesehen sind. Das isolierte Metallsubstrat ist durch die Schnittstelle flexibel einsetzbar.

In einer weiteren Ausführungsform ist die thermisch-mechanische Schnittstelle zumindest zur teilweisen stoffschlüssigen thermischen Kontaktierung der Elemente ausgebildet. Als Beispiele für stoffschlüssige thermische Kontaktierungen sind das Sintern von Kühlkörpern bzw. Kühlkörperelementen, insbesondere das Drucklossintern zu nennen.

Eine Kontaktierung der Elemente zur Schnittstelle mit Reactive-Nanofoils hat den Vorteil einer geringeren Wärmebelastung für die Leistungselektronische Baugruppe. Ebenfalls denkbar ist die Verwendung des sogenannten "Klettweldings" das vorteilhaft eine geringe Wärmebelastung aufweist.

Bei der Verwendung von laser-/ultraschallgeschweißten Elementen ist eine ausreichende Basis-Dicke vorteilhaft, um eine thermische bzw. thermomechanische Beschädigung der dielektrischen Schicht zu vermeiden.

Weiterhin ist ein gekapselter Flüssigkontakt an der Schnittstelle denkbar. Die Schnittstelle wird als Koppelfläche zu einem thermisch gut leitendem Flüssigmetall genutzt. Das Flüssigmetall ist in geeigneter Weise von einem Werkstoff und/oder einer geeigneten Geometrie der Schnittstelle umgeben, der/die die mechanische Kopplung zur Schnittstelle sicherstellt. Zur Verbesserung der flächigen Anbindung kann eine topografische Ausformung der Schnittstelle erfolgen, die die Oberfläche der Schnittstelle vergrößert, z.B. Riffelmuster. Die Elemente können weiterhin angelötet werden, z.B. mittels Diffusionslöten.

In einer weiteren vorteilhaften Ausführungsform sind die thermisch-mechanische Schnittstelle und die Basis einteilig ausgestaltet. Dies kann durch urformende Fertigungsverfahren realisiert werden. Weiterhin kann dies durch additive Fertigungsverfahren oder durch subtraktive (z.B. spanende) Fertigungsverfahren, jeweils mit bzw. ohne Halbzeug, realisiert werden. Die einteilige Ausführungsform hat den besonderen Vorteil, dass die thermisch-mechanische Schnittstelle mechanisch deutlich stabiler und auch die thermischen Übergangswiderstände auf die thermisch-mechanische Schnittstelle reduziert werden.

In einer besonders bevorzugten Ausführungsform ist die thermisch-mechanische Schnittstelle zur thermischen Anbindung von Elementen ohne thermisches Interface-Material ausgebildet. Die thermisch-mechanische Schnittstelle ist also derart ausgebildet, dass sich ein unmittelbarer Kontakt zwischen der Schnittstelle und den Elementen bilden kann.

In einer weiteren Ausführungsform weist die thermisch-mechanische Schnittstelle Nuten und/oder Federn für eine Nut-Feder-Verbindung mit den Elementen auf. Diese eignen sich durch ihre größere Oberfläche und damit besseren Wärmeübertragung und gleichzeitig mechanischen Haltefunktion besonders gut für die thermisch-mechanische Schnittstelle. Die Elemente können dann dementsprechend die Gegenstücke für die Nut-Feder-Verbindungen bilden.

Die Aufgabe wird weiterhin durch eine leistungselektronische Baugruppe gelöst, die ein isoliertes Metallsubstrat gemäß den vorstehenden Ausführungsformen sowie ein oder mehrere leistungselektronische Bauteile aufweist. Die leistungselektronischen Bauteile können dabei auf einer Leitebene angeordnet sein und mittels Bonddrähten kontaktiert werden. Bonddrahtfreie und/oder planare Kontaktierungstechnologien sind ebenso kompatibel. Das Bestücken der Baugruppe mit den leistungselektronischen Bauteilen kann dabei vorteilhaft vor dem thermischen Kontaktieren der Elemente durchgeführt werden, da das Kontaktieren der Elemente mit nur geringen thermische und/oder mechanischen Belastungen auf die Baugruppe einwirkt.

In einer vorteilhaften Ausgestaltung der Baugruppe ist die thermisch-mechanische Schnittstelle des isolierten Metallsubstrats derart angeordnet, dass der thermische Widerstand zwischen den leistungselektronischen Bauteilen und der Schnittstelle minimal ist, d.h. dass ein besonders guter Wärmeaustausch zwischen dem leistungselektronischen Bauteil und der thermischen Schnittstelle bzw. den Elementen stattfindet. Dies kann beispielsweise dadurch realisiert werden, dass die thermisch-mechanische Schnittstelle unterhalb der Montageplätze angeordnet ist und/oder Aussparungen für die Elemente unterhalb der Montageplätze der leistungselektronischen Bauelemente aufweist. Ebenso können unterhalb der leistungselektronischen Bauelemente besonders leistungsfähige Elemente, z.B. mit einer erweiterten Flüssigkühlung und/oder einer großen Oberfläche, vorgesehen werden, die einen besonders guten Wärmeabtransport ermöglichen.

Die Aufgabe wird weiterhin durch ein leistungselektronisches Modul gelöst, das zumindest eine leistungselektronische Baugruppe gemäß einer der vorstehenden Ausführungsformen sowie ein oder mehrere Elemente aufweist.

Die Aufgabe wird weiterhin durch ein leistungselektronisches System gelöst, das ein oder mehrere leistungselektronische Baugruppen und einen Träger aufweist. Der Träger weist dabei ein oder mehrere Elemente auf und ist zum thermischen Kontaktieren der einen oder mehreren leistungselektronischen Baugruppen ausgebildet. Der thermische Kontakt mit den leistungselektronischen Baugruppen wird dabei über die thermischen Schnittstellen der isolierten Metallsubstrate hergestellt. Die Elemente können dabei zu trägerseitigen Systemschnittstellen zusammengefasst sein, die als Gegenstück zur thermischen Schnittstelle des isolierten Metallsubstrats eine mechanische Haltefunktion und/oder eine thermische Kontaktfunktion zwischen dem Träger und der Baugruppe herstellen. Besonders vorteilhaft ist es, wenn das System mehrere leistungselektronische Baugruppen aufweist, so können mehrere Baugruppen auf einem einzelnen Träger mit mehreren Elementen angeordnet werden. In einer weiteren Ausführungsform des Systems sind die Elemente derart ausgestaltet, dass sie zumindest zur teilweisen mechanischen Befestigung der Baugruppe dienen.

Die Aufgabe wird weiterhin durch ein Element zur Verwendung mit einem isolierten Metallsubstrat gelöst. Das Element ist dabei derart ausgestaltet, dass es mit der thermischen Schnittstelle sowohl thermisch als auch mechanisch kontaktiert werden kann. In einer weiteren Ausführungsform ist das Element mit einer Oberflächenbeschichtung versehen, die die Wärmeleitung zwischen der thermischen Schnittstelle des isolierten Metallsubstrats und dem Element verbessert bzw. den thermischen Übergangswiderstand verringert. Die Elemente sind vorzugsweise aus gut wärmeleitenden Materialen hergestellt.

Im Folgenden wird die Erfindung anhand der in den Figuren dargestellten Ausführungsbeispiele näher beschrieben und erläutert. Es zeigen:
- FIG 1: ein isoliertes Metallsubstrat als Teil einer leistungselektronischen Baugruppe
- FIG 2: eine leistungselektronische Baugruppe mit Elementen
- FIG 3: ein modular bestücktes leistungselektronisches Modul
- FIG 4: das modular bestückte leistungselektronisches Modul aus FIG 3 in einer Ansicht von unten
- FIG 5: ein isoliertes Metallsubstrat in einer dreidimensionalen Ansicht
- FIG 6: ein isoliertes Metallsubstrat als Teil einer leistungselektronischen Baugruppe und
- FIG 7: vorteilhafte Ausführungsform eines leistungselektronischen Systems.

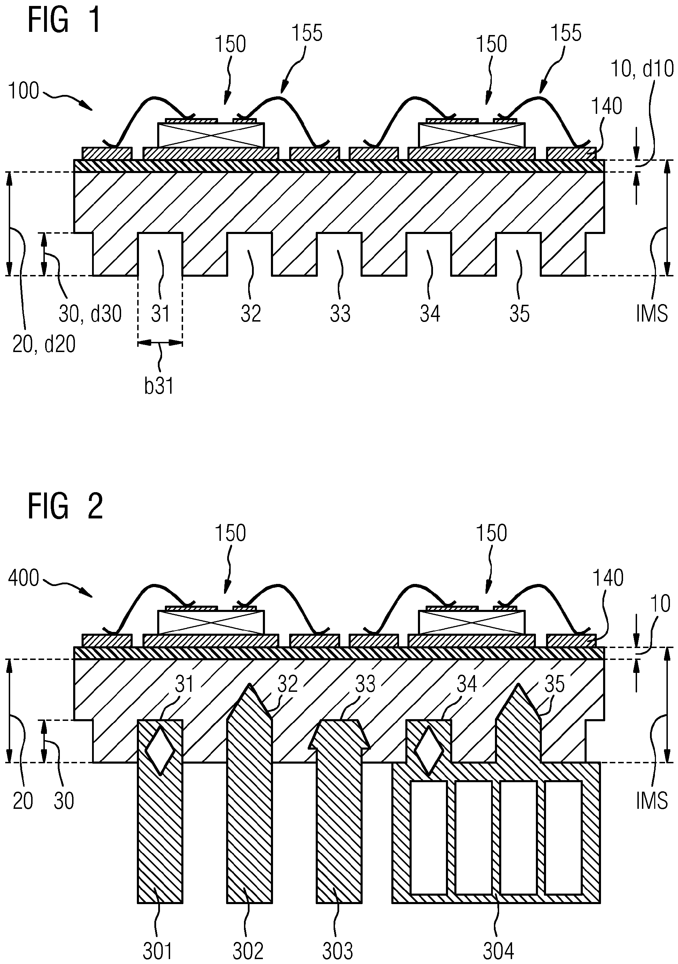

FIG 1 zeigt ein isoliertes Metallsubstrat IMS als Teil einer leistungselektronischen Baugruppe 100. Die leistungselektronische Baugruppe 100 weist weiterhin eine Leitebene 140 auf, die in diesem Fall bereits strukturiert wurde, um elektrische Verbindungen herzustellen. Die Leitebene 140 kann als eine strukturierte Multipotenzialleitebene ausgebildet sein und kann beispielsweise mit einem PCB-Verfahren, durch Belichten einer photosensitiven Schicht, Entwickeln und Ätzen hergestellt werden. Dabei kann die Leitebene flächig kaschiert, z.B. mit Kupfer, mit dem isolierten Metallsubstrat hergestellt werden und im weiteren Produktionsprozess strukturiert werden. Auf der Leitebene 140 sind leistungselektronische Bauteile 150 angebracht, die in diesem Fall mittels Bonddrähten 155 elektrisch kontaktiert wurden. Alternative Chipkontaktierungsmöglichkeiten, wie Flip Chip, Wafer Level Packages oder Ball Grid Arrays o.ä., sind ebenso möglich. Bonddrahtlose, planare Verfahren eignen sich dabei besonders gut. Bei den leistungselektronischen Bauteilen kann es sich beispielsweise um IGBTs, MOSFETs, Dioden oder weitere Leistungshalbleiter handeln. Das isolierte Metallsubstrat IMS weist eine dielektrische Schicht 10 auf, die die Leitebene 140 von einer metallischen Basis 20 des isolierten Metallsubstrats IMS trennt. Die dielektrische Schicht 10 ist so ausgelegt, dass sie thermisch gut leitend ist, also die Abwärme der leistungselektronischen Bauteile 150 an die metallische Basis 20 des isolierten Metallsubstrats IMS weiterleiten kann. Die dielektrische Schicht 10 hat eine Dicke d10 von vorzugsweise 20 bis 500 µm, insbesondere 50 bis 200 µm, und kann z. B. als keramikgefülltes Dielektrikum aus Epoxidharz ausgebildet sein. Die metallische Basis 20 dient dabei als Wärmespreizer und verteilt die aufgenommene Wärme gleichmäßig. Die metallische Basis 20 weist dabei eine Dicke d20 von vorzugsweise 0,6 bis 5 mm auf, insbesondere 1,5 bis 4mm. Des Weiteren weist das isolierte Metallsubstrat eine thermisch-mechanische Schnittstelle 30 auf, die in diesem Fall fünf Aussparungen 31,...,35 aufweist. Die Schnittstelle 30 weist eine Dicke d30 von vorzugsweise 0,3 bis 2 mm auf. Die Aussparungen 31,...,35 sind dabei vorzugsweise so ausgebildet, dass sie ein oder mehrere Elemente (nicht gezeigt) aufnehmen können, wobei die Elemente z.B. als Kühlkörper und/oder als Wärmeleitelement zur Wärmeleitung an eine Wärmesenke wie eine Wasserkühlung dienen. Die Aussparung 31 weist eine Breite b31 von vorzugsweise 0,5 mm bis 2 mm auf und steht stellvertretend für alle Aussparungen 31,...,35. Wenn Hinterschneidungen in den Aussparungen 31,...,35 vorgesehen sind, so können die Aussparungen 31,...,35 mit zunehmender Tiefe etwas breiter werden. Die Schnittstelle 30 ist dabei vorzugsweise so ausgebildet, dass die Elemente, die in die Schnittstelle 30 montierbar sind, mechanisch fixiert werden. Dies kann durch eine Ausgestaltung der Aussparungen 31,...,35 realisiert werden.

FIG 2 zeigt eine leistungselektronische Baugruppe 100, die mit Elementen 301,...,304 ein leistungselektronisches Modul 400 bildet. Die Baugruppe 100 ist ähnlich zu der in der FIG 1 gezeigten, wobei die thermisch-mechanische Schnittstelle 30 unterschiedliche Ausgestaltungen aufweist. Die Elemente 301 bis 304 sind hier bereits in der Schnittstelle 30 mechanisch befestigt; z.B. durch Montage. Das Element 301 kann dabei ein federähnliches Element aufweisen, um einen Halt in der Schnittstelle 30 zu erreichen. Das Element 301 kann dabei ein einzelner Kühlkörperstift oder eine Kühlkörperrippe sein. Ein Element 302 weist eine stiftförmige Spitze auf und kann dabei ebenfalls als Stift oder Rippe ausgebildet sein. Die Elemente 301, 302 könne dabei mit thermischen Verfahren in die Schnittstelle 30 eingebracht werden. Dazu können beispielsweise die Elemente 301, 302 abgekühlt werden und die leistungselektronische Baugruppe etwas erwärmt werden. Durch den Temperaturunterschied lassen sich die Elemente 301, 302 in die Schnittstelle 30 einführen, bei Angleichung der Temperatur entsteht mechanischer Halt. Ein Element 303 weist eine sogenannte Snap-In-Verbindung auf und kann mechanisch gesteckt werden und ist durch die Geometrie fixiert. Die Snap-In-Verbindung kann dabei so ausgestaltet sein, dass nach einmaligem Stecken das Element 303 nicht mehr lösbar verbunden ist. Ein Element 304 zeigt einen größeren Kühlkörper, der ähnlich wie die Elemente 301 und 302 ein federähnliches Element sowie eine stiftförmige Spitze aufweist. Das Element 304 bzw. der Kühlkörper erstreckt sich dabei über zwei Aussparungen 34, 35, wobei hier auch andere Formen der Kontaktierung und andere Anzahlen der Aussparungen je nach Größe und Art des Kühlkörpers möglich sind.

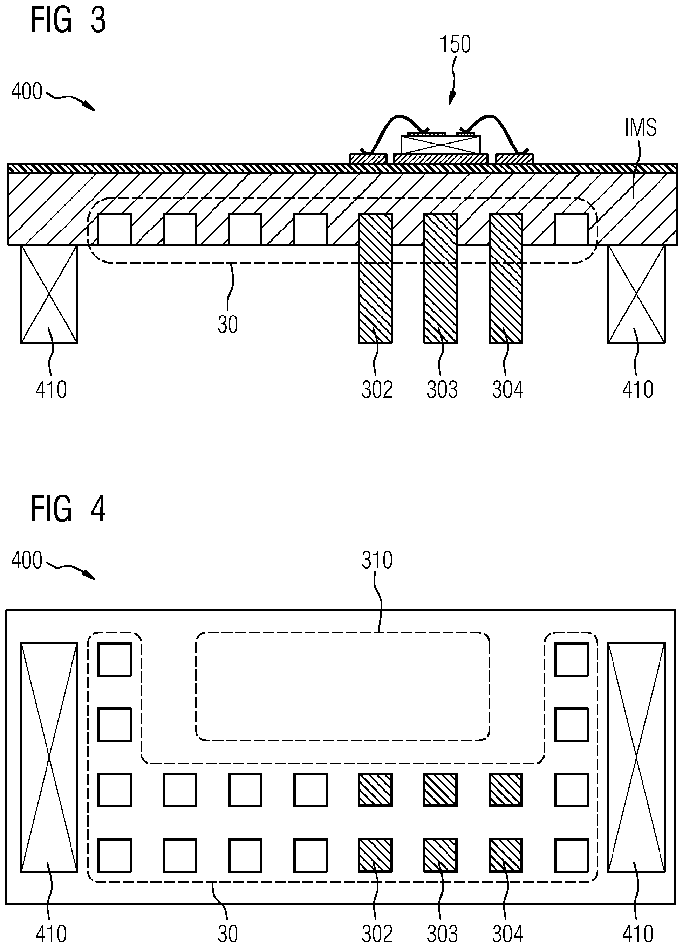

In FIG 3 zeigt ein modular bestücktes leistungselektronisches Modul 400, das neben der elektronischen Baugruppe 100 bereits mit Elementen 302, 303 und 304 bestückt ist. Das Modul 400 weist dabei nur ein leistungselektronisches Bauteil 150 auf. Weiterhin ist zu sehen, dass das Modul 400 Randelemente 410 aufweist, die beispielsweise zur mechanischen Stabilisierung und/oder zur Anbringung des isolierten Metallsubstrats IMS mit seinen leistungselektronischen Bauteilen 150 in einer übergeordneten Anordnung dienen können. Dazu könnte beispielsweise ein Gehäuse oder eine weitere Schaltung zählen. Die Randelemente können dabei Teil eines Rahmens 50 (nicht gezeigt) sein oder mit diesem verbunden werden. Die Randelemente 410 können neben ihrer mechanischen Haltefunktion auch eine Wärmeleitfunktion aufweisen.

FIG 4 zeigt das modular bestückbare leistungselektronisches Modul 400 aus FIG 3 in einer Ansicht von unten. Die Elemente 302, 303 und 304 sind stiftförmig ausgebildet, und sind so angeordnet, dass zwar in der ersten und zweiten Reihe jeweils eine Vollbesetzung mit Elementen 302,...,304 vorgesehen ist, in der dritten und vierten Reihe aber zumindest mittig keine Elemente vorgesehen sind. Diese modulare Besetzbarkeit erhöht die Flexibilität der Schnittstelle 30. Eine Fläche 310 ist frei von der Schnittstelle 30. So könnten standardisierte Metallsubstrate ausgestaltet sein, wo leistungselektronische Bauteile 150 oberhalb der Schnittstelle 30 angeordnet werden und oberhalb der Fläche 310 dementsprechend keine Abwärme erzeugenden Bauteile angeordnet werden. Die Fläche 310 kann dabei zur Anordnung von weiteren Bauteilen, wie Prozessoren, etc., dienen. Teile der Schnittstelle nicht mit Elementen 301,...,304 zu bestücken ist nicht nur effizient und kostensparend, es wird auch Bauraum gespart, wenn schlichtweg keine Elemente 302,...,304 dort angeordnet sind, wo nur wenig Abwärme entsteht. Wenig Abwärme entsteht, wenn keine leistungselektronischen Bauteile 150 an dieser Stelle vorgesehen sind oder Bauteile, die weniger Abwärme produzieren. Die modulare Bestückbarkeit ist bei allen gezeigten Ausführungsformen des isolierten Metallsubstrats IMS gegeben.

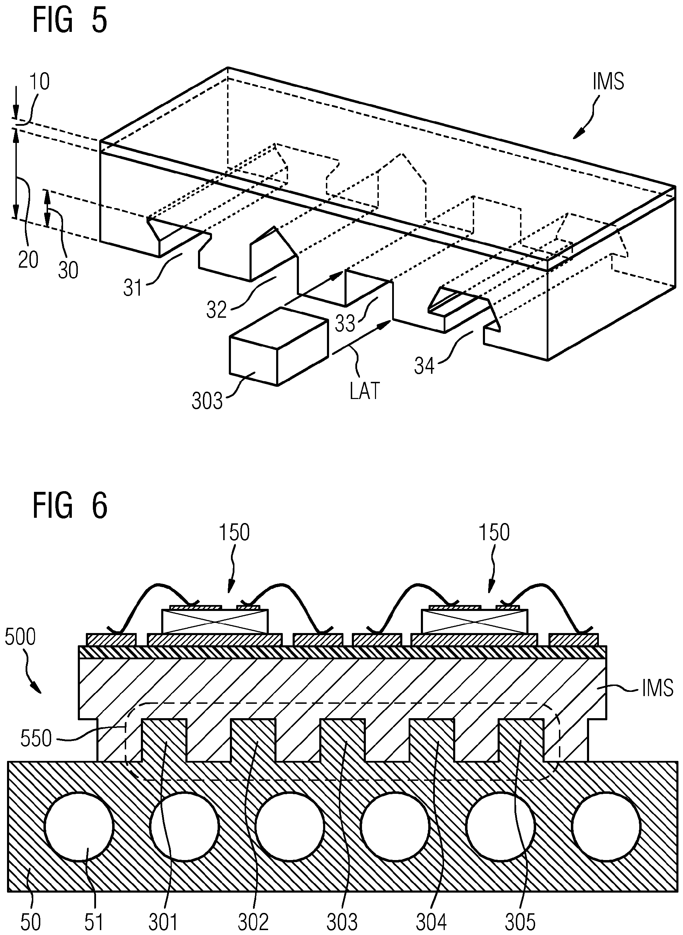

FIG 5 zeigt ein isoliertes Metallsubstrat IMS in einer dreidimensionalen Ansicht. In diesem Fall ist das isolierte Metallsubstrat IMS mit Aussparungen 31,32,33 in Form von Nuten ausgestaltet, die in diesem Fall zur lateralen Aufnahme von Elementen, z.B. wie angedeutet das Element 303, in lateraler Richtung LAT ausgeführt ist. Dies hat den besonderen Vorteil von geringen mechanischen Belastungen des isolierten Metallsubstrats IMS und der leistungselektronischen Baugruppe 100 bzw. deren leistungselektronischen Bauteile 150 (nicht gezeigt). Die Belastungen sind insbesondere geringer im Vergleich zu Verfahren, die in zur Ebene des isolierten Metallsubstrats IMS senkrechter Richtung Kräfte ausüben.

FIG 6 zeigt ein isoliertes Metallsubstrat IMS als Teil einer leistungselektronischen Baugruppe 100, die wiederum Teil eines leistungselektronischen Systems 500 ist. Das leistungselektronische System 500 weist dabei weiterhin einen Träger 50 mit darin integrierten Kühlkanälen 51 auf. Das leistungselektronische System 500 weist dabei eine Systemschnittstelle 550 auf. Die Systemschnittstelle 550 weist, hier lediglich schematisch dargestellt, Elemente 301 bis 305 auf. Die Elemente 301 bis 305 der Systemschnittstelle 550 dienen dabei zur thermischen Kontaktierung des isolierten Metallsubstrats und führen somit in besonders vorteilhafter Weise die Wärme aus dem isolierten Metallsubstrat IMS bzw. der leistungselektronischen Baugruppe 100 ab. Die Systemschnittstelle 550 kann dabei Elemente 301 bis 305 aufweisen, die gemäß jeglicher gezeigten Ausführungsformen oder Kombinationen davon ausgestaltet sind. Die Systemschnittstelle 550 kann darüber hinaus auch derart ausgestaltet sein, dass sie für die leistungselektronische Baugruppe 100 mechanischen Halt bietet.

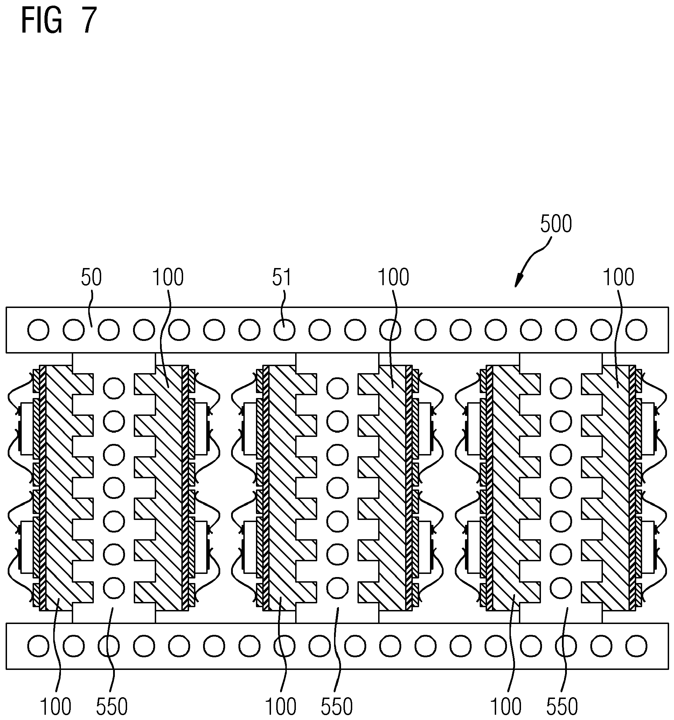

FIG 7 zeigt eine weitere besonders vorteilhafte Ausführungsform eines leistungselektronischen Systems 500 mit drei jeweils doppelseitigen Systemschnittstellen 550. Die Systemschnittstellen 550 sind dabei jeweils zum thermischen und/oder mechanischen Kontaktieren von leistungselektronischen Baugruppen 100 ausgestaltet. Die Systemschnittstellen 550 sind dabei mit einem Träger 50 verbunden, der wiederum Kühlkanäle 51 aufweist. Auch die Systemschnittstellen 550 weisen in diesem Fall eigene Kühlkanäle auf. Das Vorhandensein von Kühlkanälen 51 ist dabei optional und kann auch durch bekannte alternative Kühlmöglichkeiten ersetzt werden. Die gezeigte Ausführungsform ermöglicht leistungselektronischen Baugruppen 100 in einer besonders hohen Dichte anzuordnen und dank der Kühlinfrastruktur aus den Systemschnittstellen 550 und den Trägern 50 effizient zu kühlen.

Zusammenfassend betrifft die Erfindung ein isoliertes Metallsubstrat IMS für eine leistungselektronische Baugruppe 100. Die Erfindung betrifft weiterhin eine leistungselektronische Baugruppe 100, ein leistungselektronisches Modul 400, ein System 500 sowie ein Element 301,...,305. Um leistungselektronische Baugruppen 100 mit isolierten Metallsubstraten IMS ohne thermische Interface-Materialien zu ermöglichen wird ein isoliertes Metallsubstrat IMS für eine Abwärme erzeugende leistungselektronische Baugruppe 100 vorgeschlagen. Das isolierte Metallsubstrat IMS weist eine dielektrische Schicht 10, eine metallische Basis 20 und zumindest eine thermisch-mechanische Schnittstelle 30 auf. Die thermisch-mechanische Schnittstelle 30 ist zum Ableiten der Abwärme aus der Basis 20 und zur thermischen Kontaktierung eines oder mehrerer Elemente 301,...,305 ausgebildet.

## Patentansprüche

1. Isoliertes Metallsubstrat (IMS) für eine Abwärme erzeugende leistungselektronische Baugruppe (100) aufweisend eine dielektrische Schicht (10), eine metallische Basis (20) und zumindest eine thermisch-mechanische Schnittstelle (30), wobei die thermisch-mechanische Schnittstelle (30) zum Ableiten der Abwärme aus der Basis (20) und zur thermischen Kontaktierung eines oder mehrerer Elemente (301,...,305) ausgebildet ist.

2. Isoliertes Metallsubstrat (IMS) nach Anspruch 1, wobei die thermisch-mechanische Schnittstelle (30) zumindest zur teilweisen mechanischen Befestigung der Elemente (301,...,305) ausgebildet ist.

3. Isoliertes Metallsubstrat (IMS) nach Anspruch 1 oder 2, wobei die thermisch-mechanische Schnittstelle (30) eine oder mehrere Aussparungen (31,...,35) aufweist.

4. Isoliertes Metallsubstrat (IMS) nach einem der vorhergehenden Ansprüche, wobei die thermisch-mechanische Schnittstelle (30) eine oder mehrere Aussparungen (31,...,35) aufweist, die derart ausgebildet sind, dass eines oder mehrere der Elemente (301,...,305) lateral einführbar sind.

5. Isoliertes Metallsubstrat (IMS) nach einem der vorhergehenden Ansprüche, wobei die thermisch-mechanische Schnittstelle (30) zur formschlüssigen und/oder kraftschlüssigen mechanischen Verbindung mit den Elementen (301,...,305) ausgebildet ist.

6. Isoliertes Metallsubstrat (IMS) nach einem der vorhergehenden Ansprüche, wobei die thermisch-mechanische Schnittstelle (30) zumindest zur teilweisen stoffschlüssigen thermischen Kontaktierung der Elemente (301,...,305) ausgebildet ist.

7. Isoliertes Metallsubstrat (IMS) nach einem der vorhergehenden Ansprüche, wobei die thermisch-mechanische Schnittstelle (30) und die Basis (20) einteilig ausgestaltet sind.

8. Isoliertes Metallsubstrat (IMS) nach einem der vorhergehenden Ansprüche, wobei die thermisch-mechanische Schnittstelle (30) zur thermischen Anbindung von Elementen (301,...,305) ohne thermisches Interface-Material ausgebildet ist.

9. Isoliertes Metallsubstrat (IMS) nach einem der vorhergehenden Ansprüche, wobei die thermisch-mechanische Schnittstelle (30) Nuten und/oder Federn für Nut-Feder-Verbindungen mit den Elementen (301,...,305) aufweist.

10. Leistungselektronische Baugruppe (100), aufweisend ein isoliertes Metallsubstrat (IMS) nach einem der vorhergehenden Ansprüche sowie ein oder mehrere leistungselektronische Bauteile (150).

11. Leistungselektronische Baugruppe (100) nach Anspruch 10, wobei die thermisch-mechanische Schnittstelle (30) des isolierten Metallsubstrats (IMS) derart angeordnet ist, dass der thermische Widerstand zwischen den Bauteilen (150) und der Schnittstelle (30) minimal ist.

12. Leistungselektronisches Modul (400), aufweisend eine leistungselektronische Baugruppe (100) gemäß Anspruch 9, sowie ein oder mehrere Elemente (301,...,305).

13. Leistungselektronisches System (500) aufweisend ein oder mehrere leistungselektronische Baugruppen (100) nach Anspruch 10 oder 11 und einen Träger (50), wobei der Träger (50) ein oder mehrere Elemente (301,...,305) zum thermischen Kontaktieren der ein oder mehreren leistungselektronischen Baugruppen (100) aufweist.

14. Leistungselektronisches System (500) nach Anspruch 11, wobei die Elemente (301,...,305) derart ausgestaltet sind, dass sie zumindest zur teilweisen mechanischen Befestigung der Baugruppe (100) dienen.

15. Element (301,...,305) zur Verwendung mit einem isolierten Metallsubstrat (IMS) nach einem der Ansprüche 1 bis 8.
